# EUROPÄISCHE PATENTSCHRIFT

(11) **EP 0 362 949 B1**
(45) Veröffentlichungstag und Bekanntmachung des Hinweises auf die Patenterteilung: **14.05.1997**
(21) Anmeldenummer: 89202468.8
(22) Anmeldetag: 02.10.1989
(51) Int. Cl.: H03D 3/20

(54) **Schaltungsanordnung zum Demodulieren eines frequenzmodulierten Signals**
Circuit arrangement for the demodulation of frequency-modulated signals
Montage de circuit pour la démodulation de signaux modulés en fréquence

(30) Priorität: 07.10.1988 DE 3834118
(43) Veröffentlichungstag der Anmeldung: 11.04.1990
(73) Patentinhaber: Philips Patentverwaltung GmbH, 22335 Hamburg (DE); Philips Electronics N.V., 5621 BA Eindhoven (NL)
(72) Erfinder: Gehrt, Holger, D-2107 Rosengarten 8 (DE); Hildebrandt, Günter, D-2000 Hamburg 54 (DE); Rehfeldt, Karl-Heinz, D-2087 Ellerbek (DE)
(74) Vertreter: Peters, Carl Heinrich, Dipl.-Ing.

(56) Entgegenhaltungen:
- EP-A- 0 079 097
- EP-A- 0 278 551
- WO-A-86/05637
- DE-A- 3 702 855

## Beschreibung

Die Erfindung bezieht sich auf eine Schaltungsanordnung zum Demodulieren eines frequenzmodulierten ersten Signals zu einem demodulierten Signal.

Eine derartige Schaltungsanordnung ist aus der DE-A-37 02 855 bekannt. Sie umfaßt eine Verzögerungsanordnung, der das erste Signal zugeführt wird und die daraus durch Verzögerung um eine vorgegebene Verzögerungszeit ein zweites Signal bildet, sowie ein Exklusiv-ODER-Glied oder einen Multiplizierer, durch das bzw. den das erste und zweite Signal zu einem demodulierten Signal verknüpft werden. Dieses hat die Form einer impulsbreitenmodulierten Spannung, deren Mittelwert durch ein anschließendes Tiefpaßfilter frei von Oberwellen gewonnen werden kann. Die Breite der Impulse des Signals am Ausgang des Exklusiv-ODER-Gliedes und damit der Mittelwert am Ausgang des Tiefpaßfilters stehen mit der Frequenz des frequenzmodulierten Signals in einem linearen Zusammenhang. Veränderungen in der Frequenz des frequenzmodulierten Signals, insbesondere dessen Modulation, verändern somit den Mittelwert und damit das am Ausgang des Tiefpaßfilters abgegebene Signal, so daß die Frequenzmodulation unmittelbar in ein analoges Signal (z.B. analoge Spannung) umgesetzt wird.

EP-A-O 079 097 zeigt einen FM-Demodulator, der dadurch abgestimmt wird, daß ein Signal mit einer festen Referenzfrequenz an dem Eingang dieses FM-Demodulators zugeführt wird und daß gleichzeitig die Rückkopplungsschaltung aktiviert wird. Bei diesem FM-Demodulator erfolgt eine Nachregelung der Verzögerungszeit des Frequenzdiskriminators zu dem Zweck, Fertigungstoleranzen in der integrierten Schaltung auszugleichen, beim Einsatz in einem Multistandarddecoder eine wahlweise Abstimmung auf unterschiedliche Trägerfrequenzen nach unterschiedlichen Normen zu ermöglichen, den Frequenzdiskriminator insbesondere zur Anwendung in einem SECAM-Farbdecoder geeignet zu machen und eine Integration des Frequenzdiskriminators mit anderen Baugruppen eines Multistandard-Fernseh-Farbdecoders auf einem IC zu ermöglichen. Der FM-Demodulator umfaßt eine Rückkopplungsschaltung und einen Multiplizierer, in der Fig. 3 der EP-A-0 079 097 mit den Bezugszeichen 70 bzw. 30 versehen.

Der Multiplizierer 30 weist einen ersten Eingang 62, 63 und einen zweiten Eingang 68, 69 auf. Der erste Eingang 62, 63 ist mit dem zweiten Eingang 68, 69 über ein Verzögerungsfilter 40 verbunden, zu welchem auch - zur Veränderung der Eigenfrequenz ω₀ des Verzögerungsfilters 40 - ein Kapazitätsmultiplizierer 61 zu rechnen ist. Der Multiplizierer 30 weist ferner einen Ausgang 66, 67 auf, an den ein Filter 60 angeschlossen ist, welches zum Ausfiltern unerwünschter Frequenzkomponenten im Ausgangssignal des Multiplizierers 30 vorgesehen ist. Am Ausgang 64, 65 des Filters 60 und damit der Diskriminatoranordnung liegt dann eine Ausgangsgleichspannung an, und zwar als Differenzsignal auf einer zweipoligen Leitung. Diese Ausgangsgleichspannung wird im Komparator 71, der Teil des Rückkopplungsschaltkreises 70 ist, gemessen, und zwar ausschließlich während sogenannter Torimpulse, die über einen Anschluß 125 extern zugeführt werden. Der Regelkreis aus Verzögerungsfilter 40, Multiplizierer 30, Filter 60 und Rückkopplungsschaltkreis 70 wird nur während des Auftretens dieser Torimpulse ("Klemmperiode") wirksam geschaltet. Während dieser Klemmperiode wird die am Ausgang des Filters 60 vom Komparator 71 gemessene Gleichspannung im wesentlichen auf Null geregelt. Dem Rückkopplungsschaltkreis 70 wird über einen Steuereingang 109 eine Gleichspannung zugeführt, durch die der Diskriminator auf verschiedene Trägerfrequenzen abgestimmt werden kann. Dies erfolgt dadurch, daß während der Klemmperiode dem ersten Eingang 62, 63 des Multiplizierers 30 ein definiertes Signal zugeleitet wird, daß dieses Signal eine bestimmte Ausgangsgleichspannung am Ausgang 64, 65 hervorruft, daß diese Ausgangsgleichspannung im Komparator 71 gemessen wird und aufgrund dieses Meßergebnisses ein mit der Rückkopplungsschaltung 70 verbundener Speicherkondensator so lange umgeladen wird, bis - durch Steuerung über den Rückkopplungsverstärker 92 innerhalb der Rückkopplungsschaltung 70 und damit der Steuerung der Zeitkonstanten τ₂ - die Ausgangsgleichspannung am Ausgang 64, 65 im wesentlichen Null ist.

Durch diese Regelung der Spannung auf einen vorgegebenen Wert erfolgt somit eine Frequenzeinstellung des Diskriminators für eine Frequenzband- bzw. Kanalwahl und für den Ausgleich von Fertigungstoleranzen. Dabei bleibt die Übertragungs-Kennlinie des Diskriminators unverändert.

Für den Fall, daß die Trägerfrequenz des frequenzmodulierten Signals einen festen, stabilen Wert einnimmt, gibt das Signal am Ausgang des Tiefpaßfilters korrekt den Wert der Frequenzmodulation der Trägerfrequenz des frequenzmodulierten Signals wieder. Schwankt dagegen die Trägerfrequenz, werden diese Schwankungen auf den Mittelwert übertragen und verfälschen somit den vom frequenzmodulierten Signai übertragenen Informationsinhalt. Dieser Fall kann beispielsweise dann auftreten, wenn das frequenzmodulierte Signal von einem gegenüber einer Auslesevorrichtung mechanisch bewegten Aufzeichnungsträger ausgelesen wird.

Die Erfindung hat die Aufgabe, eine Schaltungsanordnung der eingangs genannten Art derart auszubilden, daß Schwankungen der Trägerfrequenz keinen Einfluß auf den Mittelwert des demodulierten Signals und damit auf den aus dem frequenzmodulierten Signal zu gewinnenden Informationsinhalt haben.

Die Aufgabe wird bei einer Schaltungsanordnung der gattungsgemäßen Art erfindungsgemäß gelöst durch die kennzeichnenden Merkmale des Patentanspruchs 1.

Die Erfindung nutzt den direkten Zusammenhang zwischen dem Mittelwert des Signals am Ausgang des Frequenz-Demodulators bzw. des zugehörigen Tiefpaßfilters und der Frequenz des frequenzmodulierten Signals. Die Steilheit dieser Demodulationskennlinie bestimmt sowohl den zu einem vorgegebenen Frequenzhub des frequenzmodulierten Signals zugeordneten Amplitudenhubes des Mittelwertes als auch die Zuordnung einer bestimmten Frequenz im gesamten Frequenzspektrum des frequenzmodulierten Signals zu einem bestimmten Mittelwert. Bei einer vorgegebenen Steilheit der Demodulationskennlinie ist somit der Amplitudenhub des Mittelwertes unmittelbar korreliert mit dem Mittelwert für eine bestimmte Frequenz im frequenzmodulierten Signal. Entspricht diese Frequenz einem Bezugspegel im zu übertragenden Informationsinhalt, kann aus der Detektion dieses Bezugspegels im demodulierten Signal - insbesondere in dessen Mittelwert - auf die Abweichung der zugehörigen Frequenz des frequenzmodulierten Signals von ihrem Sollwert und damit auf die Abweichung des Amplitudenhubes des Mittelwerts von seinem Sollwert geschlossen werden. Erfindungsgemäß wird nun die Steilheit der Demodulationskennlinie über eine Einstellvorrichtung derart eingestellt, daß trotz der Frequenzabweichung der Sollwert des Amplitudenhubes des Mittelwertes erreicht wird. Aufgrund der beschriebenen direkten Korrelation wird als Stellgröße für diese Regelung der Amplitude des demodulierten Signals unmittelbar der detektierte Bezugspegel der Einstellvorrichtung zugeführt.

Die Erfindung ermöglicht somit in sehr einfacher Weise eine Regelung sowohl des Bezugspegels als auch des Amplitudenhubes auf die gewünschten Sollwerte in einem einzigen Regelkreis. Diese Regelung ist einfach aufgebaut, weist eine hohe Regelgeschwindigkeit und hohe Stabilität, d.h. geringe Neigung zu Eigenschwingungen auf.

An dieser Stelle sei bemerkt, daß aus der WO-A-86/05637 eine Schaltung zur automatischen Scharfabstimmung für FM-Empfänger bekannt ist, insbesondere für Empfänger mit schmalbandigen Mitlauffiltern. Diese Empfänger weisen üblicherweise eine von einem Oszillator gesteuerte Mischstufe, mindestens ein Filter zum Ausfiltern der ZF-Signale und einen Demodulator auf. Die Scharfabstimmung erfolgt über eine geschlossene Regelschleife, wobei in einer Ausführung der Mittelwert der Ausgangsspannung des Demodulators gebildet wird und mit einer die Referenzlage des Zwischenfrequenzsignals angebenden Sollspannung verglichen wird. Abhängig von der Abweichung zwischen Mittelwert und Sollspannung wird die Frequenz des Oszillators nachgeregelt. In einer anderen Ausführung wird der Mittelwert der ZF-Frequenz gebildet, der mit einer die Referenzlage der Zwischenfrequenz angebenden Sollfrequenz verglichen wird, wobei abhängig von der Abweichung zwischen dem Mittelwert der ZF-Frequenz und der Sollfrequenz die Frequenz des Oszillators nachgeregelt wird.

In einer bevorzugten Ausführung der erfindungsgemäßen Schaltungsanordnung mit einer Verzögerungsanordnung, der das erste Signal zugeführt wird und die daraus durch Verzögerung um eine vorgegebene Verzögerungszeit ein zweites Signal bildet, sowie einer Signalverknüpfungsstufe, insbesondere einem Exklusiv-ODER-Glied oder einem Multiplizierer, durch die das erste und zweite Signal zum demodulierten Signal verknüpft werden, ist die Verzögerungszeit von der Einstellvorrichtung einstellbar. Eine solche Anordnung weist eine lineare Demodulationskennlinie auf, deren Steilheit, d.h. Steigung, durch Einstellen der Verzögerungszeit einfach und wirksam verändert werden kann. Beispiele für den Aufbau einer derartigen Verzögerungsanordnung sind aus den deutschen Offenlegungsschriften DE-A-37 02 854, 37 02 855 und 37 06 319 bekannt und sollen hier nicht näher beschrieben werden. Die darin beschriebenen Möglichkeiten bzw. Vorrichtungen zur Einstellung der Verzögerungszeit können für die vorliegende Erfindung unmittelbar als Einstellvorrichtung herangezogen werden.

In besonders vorteilhafter Weise läßt sich weiterhin die erfindungsgemäße Schaltungsanordnung mit einem Frequenzhubdetektor zum Detektieren der Überschreitung eines vorgegebenen Frequenzhubbereiches durch die Frequenz des ersten Signals verbinden, wobei der Frequenzhubdetektor ein Fehleranzeigesignal liefert, wenn die Phasenverschiebung zwischen dem ersten und dem zweiten Signal dem Frequenzhubbereich entsprechende Grenzwerte überschreitet.

Ein derartiger Frequenzhubdetektor findet bevorzugt Anwendung bei der Auswertung eines von einem mechanisch bewegten Aufzeichnungsträgers gelesenen frequenzmodulierten Signals. Störungen dieses Aufzeichnungsträgers wie beispielsweise Fabrikationsfehler oder Beschädigungen, die für ein bestimmtes Zeitintervall ein Ausbleiben des frequenzmodulierten ersten Signals hervorrufen, machen sich dadurch bemerkbar, daß die Frequenz dieses ersten Signals bestimmte, vorgebbare Grenzwerte überschreitet. Wird ein solches Überschreiten festgestellt, können von nachgeschalteten Signalauswerteanordnungen, die durch das Fehleranzeigesignal gesteuert werden, Maßnahmen zum Ausgleich oder zur überbrückung der Fehler eingeleitet werden.

Zu einer besonders weitgehenden Einsparung von Bauteilen und damit Vereinfachung des Schaltungsaufbaus einerseits gelangt man dabei, wenn der Frequenzhubdetektor in der aus der DE-A- 37 02 856 beschriebenen Weise aufgebaut ist und mit der Schaltungsanordnung zum Demodulieren des ersten Signals die Verzögerungsanordnung gemeinsam ausnutzt. Darüber hinaus ergibt sich der Vorteil, daß mit dem Einstellen der Steilheit der Demodulationskennlinie über eine vom Bezugspegel abhängige Nachführung der Verzögerungszeit der Verzögerungsanordnung zugleich auch die dem Frequenzhubbereich entsprechenden Grenzwerte nachgeregelt werden. Würden diese im Gegensatz dazu unabhängig von den auszuregelnden Schwankungen der Trägerfrequenz des frequenzmodulierten Signals fest vorgegeben sein, könnten sich im ungünstigen Fall diese Schwankungen mit dem zum Informationsinhalt gehörenden Frequenzhub derart überlagern, daß der Frequenzhubdetektor selbst bei ungestörtem Informationsinhalt einen Fehler im frequenzmodulierten ersten Signal anzeigt. Dies würde beispielsweise beim Anlauf eines mechanisch bewegten Aufzeichnungsträgers ungünstige Folgen haben. Durch die beschriebene Ausbildung des Frequenzhubdetektors ist es dagegen möglich, beispielsweise bereits beim Anlaufen des Aufzeichnungsträgers oder bei dessen Schnellauf verwertbare Signale zu gewinnen, etwa zur Steuerung der Bewegung des Aufzeichnungsträgers.

Ausführungsbeispiele der Erfindung sind in der Zeichnung dargestellt und werden im nachfolgenden näher beschrieben. Es zeigen
- Fig. 1 bis 3: blockschematische Darstellungen erfindungsgemäßer Schaltungsanordnungen,
- Fig. 4: die Funktionsweise der Erfindung anhand einer Demodulatorkennlinie.

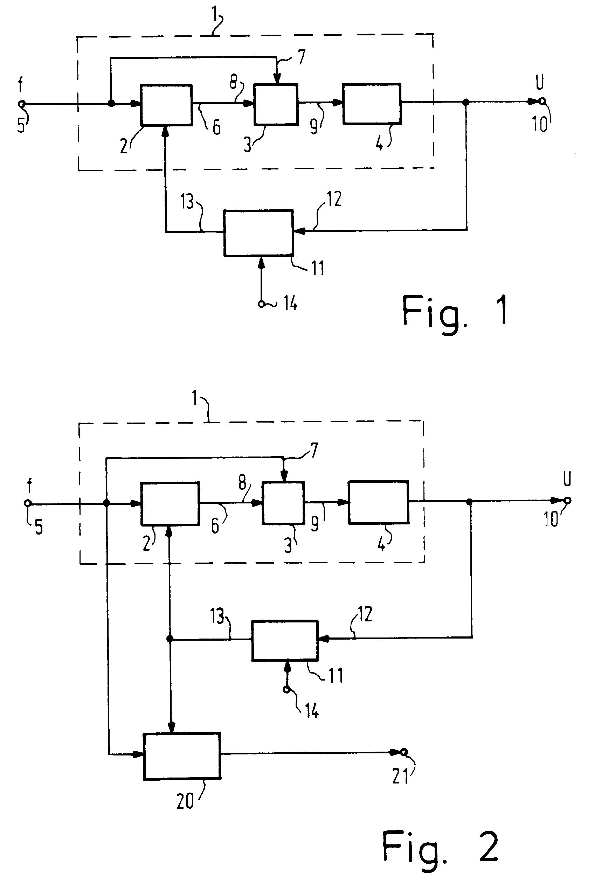

Fig. 1 zeigt einen Frequenzdemodulator 1, der durch eine gestrichelte Linie umfahren ist und eine Verzögerungsanordnung 2, eine Signalverknüpfungsstufe 3 sowie ein Tiefpaßfilter 4 umfaßt. Von einem Eingang 5 gelangt ein frequenzmdouliertes, amplitudenbegrenztes erstes Signal auf die Verzögerungsanordnung 2, die daraus ein um eine vorgegebene Verzögerungszeit verzögertes zweites Signal bildet und an ihrem Ausgang 6 abgibt.

Der Signalverknüpfungsstufe 3, die beispielsweise als Exklusiv-Oder-Glied oder als Multiplizierer ausgebildet sein kann, wird an einem ersten Eingang 7 das erste Signal und an einem zweiten Eingang 8 das zweite Signal zugeführt. Am Ausgang 9 der Signalverknüpfungsstufe 3 tritt ein demoduliertes Signal auf mit einem hohen Spannungspegel in den Zeitintervallen, in denen die Spannungspegel des ersten und des zweiten Signals voneinander abweichen, und einem niedrigen Spannungspegel, wenn sie übereinstimmen, für den Fall, daß die Signalverknüpfungsstufe 3 als Exklusiv-Oder-Glied ausgebildet ist. Wird statt dessen ein Multiplizierer eingesetzt, ergibt sich am Ausgang 9 ein hoher Spannungspegel in den Zeitintervallen, in denen die Spannungspegel des ersten und des zweiten Signals übereinstimmen, und im übrigen ein niedriger Spannungspegel. Das im einen Fall gewonnene Signal am Ausgang 9 ist also zu dem im anderen Fall gewonnenen Signal invers.

Im nachgeschalteten Tiefpaßfilter 4 werden die in dem Signal vom Ausgang 9 enthaltenen höherfrequenten Signalanteile unterdrückt, so daß am Ausgang 10 des Tiefpaßfilters 4 ein oberwellenfreies demoduliertes Signal abgegeben wird. Dieses entspricht dem Gleichspannungsanteil bzw. Mittelwert des Signals am Ausgang der Signalverknüpfungsstufe 3. Auf diese Weise bildet der Frequenzdemodulator 1 aus dem ihm am Eingang 5 zugeleiteten frequenzmodulierten Signal eine analoge Spannung. Vorzugsweise ist der Wert dieser Spannung proportional der Frequenz des frequenzmodulierten ersten Signals, wobei der Proportionalitätsfaktor, das ist die Steilheit der Demodulationskennlinie zwischen der Frequenz am Eingang 5 und der Spannung am Ausgang 10, von der Verzögerungszeit der Verzögerungsanordnung 2 abhängt. Mit zunehmender Verzögerungszeit nimmt auch die Steilheit der Demodulationskennlinie zu.

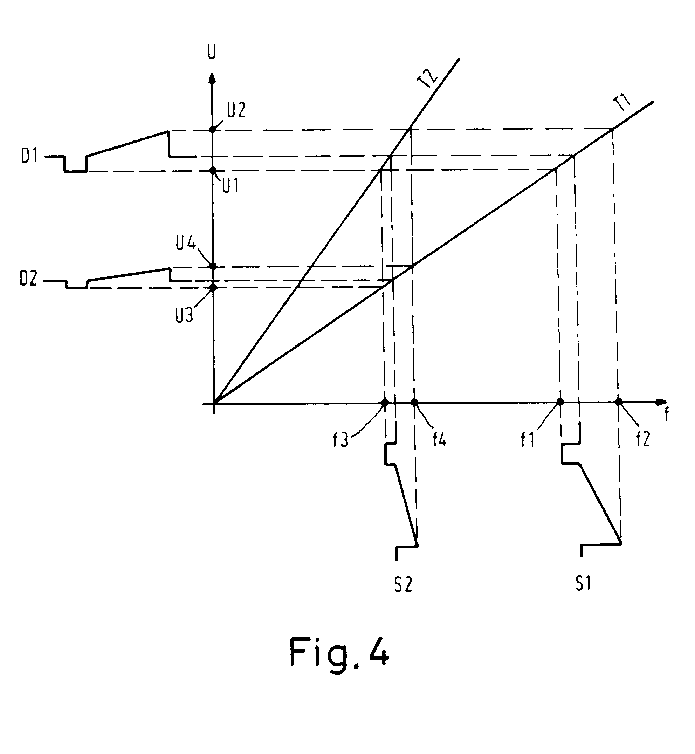

Fig. 4 zeigt als Beispiel eine lineare Demodulationskennlinie in einem Diagramm, bei dem die Spannung U am Ausgang 10 über der Frequenz f des ersten Signals am Eingang 5 aufgetragen ist. Für einen bestimmten Wert der Verzögerungszeit der Verzögerungsanordnung 2 hat diese Demodulationskennlinie den mit T1 bezeichneten Verlauf. Das frequenzmodulierte erste Signal weist in einer Sollage einen durch Frequenzhubgrenzen f1 und f2 berandeten Frequenzhubbereich auf. Beispielsweise variiert die Frequenz f des ersten Signals im Frequenzhubbereich gemäß einem schematisch dargestellten und mit S1 bezeichneten Signal. Die Zeitachse für dieses schematisch dargestellte Signal S1 ist in Fig. 4 senkrecht nach unten verlaufend gedacht. Das Signal S1 stellt beispielsweise ein Videosignal im Basisband dar.

Durch die Demodulation gemäß der Demodulationskennlinie T1 liefert der Frequenzdemodulator 1 aus Fig. 1 am Ausgang 10 einen Spannungsverlauf, wie er in Fig. 4 mit D1 bezeichnet ist. Die Spannung U variiert dabei korreliert mit der Frequenz f zwischen Spannungshubgrenzen U1 und U2. Einem vorgegebenen Frequenzhubbereich entspricht damit ein bestimmter Spannungshubbereich.

Verschiebt sich der Frequenzhubbereich aus seiner Sollage zwischen den Frequenzhubgrenzen f1 und f2 beispielsweise bei einer Verzögerung der Bewegung eines Aufzeichnungsträgers, von dem das erste Signal ausgelesen wurde, in einen Frequenzhubbereich zwischen Frequenzhubgrenzen f3 und f4 (Istlage), entsteht an der Demodulationskennlinie T1 aus dem jetzt gemäß dem Verlauf S2 in der Frequenz f variierenden ersten Signal eine Spannung, deren Verlauf mit D2 bezeichnet ist. Die Spannung D2 variiert innerhalb eines durch Spannungshubgrenzen U3 und U4 berandeten Spannungshubbereiches. Es ist zu erkennen, daß die Spannungswerte und auch die Breite des Spannungshubbereiches in dieser Istlage zwischen den Spannungshubgrenzen U3 und U4 gegenüber der Sollage verringert sind.

Um aus einem ersten Signal mit einem von der Sollage abweichenden Frequenzhubbereich, beispielsweise gemäß einem Verlauf S2, unverändert eine Spannung mit einem Verlauf D1 zu erzeugen, wird nach der Erfindung die Steilheit der Demodulationskennlinie eingestellt. Dazu enthält die Anordnung nach Fig. 1 einen Bezugspegeldetektor 11 zum Detektieren eines Bezugspegels im demodulierten Signal, d.h. in der Spannung U am Ausgang 10, der dazu mit einem Bezugspegeleingang 12 des Bezugspegeldetektors 11 verbunden ist. Der Bezugspegeldetektor 11 detektiert im Spannungsverlauf D1 bzw. D2 beispielsweise den niedrigsten Wert entsprechend den Spannungshubgrenzen U1 bzw. U3; es können aber auch - je nach dem Verlauf des ersten Signals - andere Bezugspegel im demodulierten Signal auftreten und detektiert werden. Der Bezugspegeldetektor 11 liefert an einem Einstellausgang 13 ein Einstellsignal, das mit dem Bezugspegel übereinstimmt oder entsprechend diesem gebildet ist. Dieses wird dem Frequenzdemodulator 1 zugeleitet.

Der Frequenzdemodulator 1 gemäß Fig. 1 enthält innerhalb der Verzögerungsanordnung 2 eine Einstellvorrichtung, mit der die Steilheit der Demodulationskennlinie zum Regeln der Amplitude des demodulierten Signals eingestellt werden kann. Diese Einstellvorrichtung bewirkt eine entsprechende Veränderung der Verzögerungszeit der Verzögerungsanordnung 2. Derartige Einstellvorrichtungen sind in den deutschen Patentanmeldungen P 37 02 854.5 und P 37 06 319.7 dargestellt.

Durch Einstellen der Verzögerungszeit wird für den Frequenzdemodulator 1 im Beispiel nach Fig. 4 eine Demodulationskennlinie mit einem Verlauf T2 erhalten, der sich durch eine vergrößerte Verzögerungszeit und damit größere Steilheit auszeichnet. Über die Demodulationskennlinie T2 wird aus dem ersten Signal gemäß S2 ein demoduliertes Signal, d.h. eine Spannung gemäß dem Verlauf D1 gewonnen. Der Spannungshubbereich ändert sich somit bei einer Verschiebung des Frequenzhubbereiches nicht. Das Signal am Ausgang 10 ist somit unabhängig von Frequenzverschiebungen im ersten Signal.

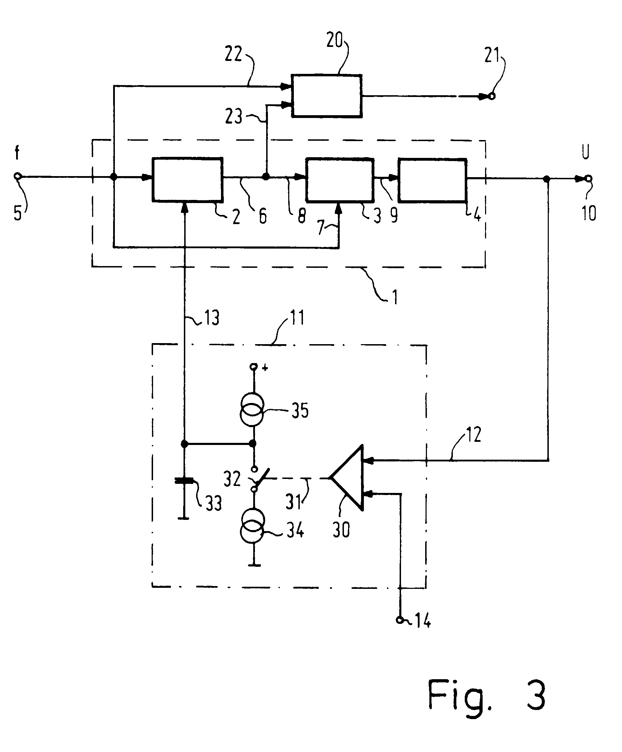

Fig. 2 zeigt eine Erweiterung der Schaltungsanordnung nach Fig. 1, in der im übrigen bereits beschriebene Bestandteile wieder mit identischen Bezugszeichen versehen sind. Zusätzlich umfaßt die Anordnung nach Fig. 2 einen Frequenzhubdetektor 20 zum Detektieren des Frequenzhubes bzw. der Variation der Frequenz des ersten Signals am Eingang 5. Der Frequenzhubdetektor 20 liefert an einem Ausgang 21 ein Fehleranzeigesignal, wenn die aktuelle Frequenz des ersten Signals vorgegebene Grenzwerte überschreitet. Dadurch können beispielsweise Signalausfälle im ersten Signal festgestellt werden. Um zu verhindern, daß der Frequenzhubdetektor 20 eine Verschiebung der Frequenzen des ersten Signals aus der Sollage über die Grenzwerte hinaus als Ausfall des ersten Signals detektiert, obwohl dieses noch vollständig vorhanden ist, wird dem Frequenzhubdetektor 20 ebenfalls das Einstellsignal vom Einstellausgang 13 des Bezugspegeldetektors 11 zugeführt. Da dieses ein direktes Maß für die Istlage der Frequenz des ersten Signals darstellt, können damit unmittelbar auch die Grenzwerte eingestellt werden, die sich in bestimmten Frequenzabständen unterhalb bzw. oberhalb des Frequenzhubbereichs befinden.

Fig. 3 zeigt eine besonders vorteilhafte Weiterbildung des Beispiels gemäß Fig. 2, in der im übrigen mit Fig. 2 übereinstimmende Teile wieder mit denselben Bezugszeichen versehen sind. Dem Frequenzhubdetektor 20 wird darin über einen ersten Eingang 22 das erste Signal und über einen zweiten Eingang 23 das zweite Signal vom Eingang bzw. Ausgang der Verzögerungsanordnung 2 zugeführt. Der Frequenzhubdetektor 20 kann dabei wie in der deutschen Patentanmeldung P37 02 856.1 dargestellt ausgebildet sein. Der erste Eingang 22 entspricht dann dem dortigen Steuereingang 10, der zweite Eingang 23 dem dortigen Dateneingang 11. Bei dieser Ausbildung der Schaltungsanordnung wird nicht nur die Verzögerungsanordnung 2 doppelt ausgenutzt, nämlich sowohl für den Frequenzdemodulator 1 als auch für den Frequenzhubdetektor 20, sondern mit der Einstellung der Verzögerungszeit der Verzögerungsanordnung 2 wird zugleich eine passende Verschiebung der Grenzwerte des Frequenzhubdetektors 20 vorgenommen. Der Frequenzhubdetektor 20 benötigt daher keine gesonderte Einstellvorrichtung zum Verschieben der Grenzwerte. Dadurch wird der Schaltungsaufbau sehr einfach und funktionssicher.

Fig. 3 zeigt weiterhin ein etwas detaillierteres Beispiel für den Aufbau des Bezugspegeldetektors 11. Dieser enthält eine Komparatorstufe 30, in der die Spannung U vom Ausgang 10 - über den Bezugspegeleingang 12 zugeführt - mit einem über einen Referenzsignaleingang 14 zugeleiteten Referenzsignal - vorzugsweise einem konstanten Spannungspegel - verglichen wird. Unterschreitet die Spannung U den Wert des Referenzsignals am Referenzsignaleingang 14, wird von der Komparatorstufe 30 über eine Wirkverbindung 31 ein Schalter 32 in den leitenden Zustand überführt und dadurch ein Kondensator 33 mit einem von einer Stromquelle 34 hervorgerufenen Entladestrom beaufschlagt. Der Kondensator 33 wird durch die Stromquelle 34 nur während der negativen Spitzen der Spannung U entladen, jedoch durchgehend mit einem geringen Ladestrom aus einer weiteren Stromquelle 35 aufgeladen. Bei aufeinander abgestimmter Dimensionierung der Stromquellen 34, 35 und des Kondensators 33 führt dieser im Betrieb stets den Wert der Spannung U zum Zeitpunkt der negativen Spannungsspitzen des Signals am Ausgang 10. In Fig. 4 ist dies die Spannungshubgrenze U1 des Spannungsverlaufs D1. Diese Spannung wird über den Einstellausgang 13 zur Einstellung der Verzögerungszeit der Verzögerungsanordnung 2 zugeleitet.

Sinkt die Frequenz f des ersten Signals, sinkt damit zunächst die Spannung U und damit auch der Wert der negativen Spannungsspitzen. Dadurch verlängern sich die Zeitintervalle, in denen der Schalter 32 leitend ist, so daß die Spannung, auf die der Kondensator 33 aufgeladen ist, sinkt. Entsprechend wird über den Einstellausgang 13 die Verzögerungszeit und damit die Steilheit des Frequenzdemodulators 1 im Sinne eines Übergangs von der Demodulatorkennlinie T1 auf die Demodulatorkennlinie T2 nachgeführt, wodurch auch die Spannung U nachgeführt wird.

Die beschriebenen Schaltungsanordnungen werden bevorzugt für die Aufbereitung eines frequenzmodulierten Signals von einem Aufzeichnungsträger, insbesondere einer optisch bespielten Platte, eingesetzt. Durch sie wird erreicht, daß auch bei Drehzahlveränderungen dieser Platte, insbesondere beim Anlauf oder beim Auslauf, auf einfache Weise stets ein auf einen bestimmten Spannungspegel geklemmtes und zugleich in seiner Amplitude geregeltes demoduliertes Signal für die weitere Signalauswertung zur Verfügung steht.

## Patentansprüche

1. Schaltungsanordnung zum Demodulieren eines frequenzmodulierten ersten Signals (an 5) zu einem demodulierten Signal (an 9 bzw. 10),
gekennzeichnet durch einen Bezugspegeldetektor (11) zum Detektieren eines Bezugspegels (U1) im demodulierten Signal (an 9 bzw. 10) und eine Einstellvorrichtung (in 2) zum Einstellen der Steilheit der Demodulationskennlinie, wobei der Bezugspegel (U1) der Einstellvorrichtung (in 2) zum Regeln der Amplitude des demodulierten Signals (an 9 bzw. 10) derart zugeführt wird, daß Schwankungen der Trägerfrequenz keinen Einfluß auf den Mittelwert des demodulierten Signals haben.

2. Schaltungsanordnung nach Anspruch 1 mit einer Verzögerungsanordnung (2), der das erste Signal (an 5) zugeführt wird und die daraus durch Verzögerung um eine vorgegebene Verzögerungszeit ein zweites Signal (an 6) bildet, sowie einer Signalverknüpfungsstufe (3), durch die das erste und zweite Signal (an 5 und 6) zum demodulierten Signal (an 9 bzw. 10) verknüpft werden,
dadurch gekennzeichnet, daß die Verzögerungszeit von der Einstellvorrichtung (in 2) einstellbar ist.

3. Schaltungsanordnung nach Anspruch 2,
gekennzeichnet durch einen Frequenzhubdetektor (20) zum Detektieren der überschreitung eines vorgegebenen Frequenzhubbereiches durch die Frequenz (f) des ersten Signals (an 5), wobei der Frequenzhubdetektor (20) ein Fehleranzeigesignal (an 21) liefert, wenn die Phasenverschiebung zwischen dem ersten und dem zweiten Signal (an 5 bzw. 6) dem Frequenzhubbereich entsprechende Grenzwerte überschreitet.

4. Gerät zum Auslesen eines frequenzmodulierten Signals von einem Aufzeichnungsträger, insbesondere einer optisch bespielten Platte,
gekennzeichnet durch eine Schaltungsanordnung nach einem der Ansprüche 1 bis 3.

## Claims

1. A circuit arrangement for demodulating a frequency-modulated first signal (5) into a demodulated signal (9 or 10), characterized by a reference level detector (11) for detecting a reference level (U1) in the demodulated signal (9 or 10) and a setting device (2) for setting the slope of the demodulation characteristic, the reference level (U1) being supplied to the setting device (2) for controlling the amplitude of the demodulated signal (9 or 10) so that fluctuations of the carrier frequency have no effect on the mean value of the demodulated signal.

2. A circuit arrangement as claimed in Claim 1, including a delay arrangement (2) to which the first signal is applied (5) and which forms therefrom a second signal (6) by producing a delay of a predetermined time, as well as a signal combining stage (3) which combines the first and second signals (5 and 6) to form the demodulated signal (9 or 10), characterized in that the time delay produced by the setting device (2) is adjustable.

3. A circuit arrangement as claimed in Claim 2, characterized by a frequency swing detector (20) for detecting whether a predetermined frequency swing range is exceeded by the frequency (f) of the first signal (5), the frequency swing detector (20) producing an error indication signal (21) when the phase shift between the first and second signals (5 and 6) exceeds limit values corresponding to the frequency swing range.

4. Device for reading a frequency-modulated signal from a record carrier, more particularly, an optical record carrier, characterized by a circuit arrangement as claimed in one of the Claims 1 to 3.

## Revendications

1. Circuit de démodulation d'un premier signal à modulation de fréquence (en 5) en un signal démodulé (en 9 ou 10),
caractérisé par un détecteur du niveau de référence (11) pour la détection d'un niveau de référence (U1) dans le signal démodulé (en 9 ou 10) et un dispositif de réglage (en 2) pour le réglage de la pente de la caractéristique de démodulation, le niveau de référence (U1) étant amené au dispositif de réglage (en 2) en vue du réglage de l'amplitude du signal démodulé (en 9 ou 10) de telle sorte que les variations de la fréquence porteuse n'aient pas d'influence sur la valeur moyenne du signal démodulé.

2. Circuit selon la revendication 1 avec un dispositif retardateur (2) auquel est amené le premier signal (en 5) et qui forme à partir de là, par retardement d'un temps de retard prédéfini, un deuxième signal (en 6) ainsi qu'un étage de combinaison de signaux (3) par lequel les premier et deuxième signaux (en 5 et 6) sont combinés en un signal démodulé (en 9 ou 10),
caractérisé en ce que le temps de retard peut être réglé par le dispositif de réglage (en 2).

3. Circuit selon la revendication 2,
caractérisé par un détecteur d'excursion de fréquence (20) pour la détection du dépassement d'une plage d'excursion de fréquence prédéterminée par la fréquence (f) du premier signal (en 5), le détecteur d'excursion de fréquence (20) produisant un signal d'erreur (en 21) lorsque le décalage de phase entre les premier et deuxième signaux (en 5 ou 6) dépasse les valeurs limites correspondant à la plage d'excursion de fréquence.

4. Appareil de sortie d'un signal à modulation de fréquence par un support d'enregistrement, en particulier d'un disque à lecture optique,
caractérisé par un circuit selon l'une des revendications 1 à 3.
